Europäisches Patentamt

European Patent Office

Office européen des brevets

(19)

(11) Numéro de publication: **0 365 405 B1**

# (12) FASCICULE DE BREVET EUROPEEN

(45) Date de publication de fascicule du brevet: **13.04.94**   (51) Int. Cl.⁵: **H03M 7/40**

(21) Numéro de dépôt: **89402831.5**

(22) Date de dépôt: **13.10.89**

---

(54) **Procédé de codage adapté à la reconnaissance de mots de synchronisation dans des suites de mots codés à longueurs variables.**

---

(30) Priorité: **19.10.88 FR 8813760**

(43) Date de publication de la demande:
**25.04.90 Bulletin 90/17**

(45) Mention de la délivrance du brevet:
**13.04.94 Bulletin 94/15**

(84) Etats contractants désignés:
**AT CH DE ES GB LI NL SE**

(56) Documents cités:
EP-A- 0 139 511
EP-A- 0 208 537
GB-A- 2 123 654
US-A- 4 539 684

IEE PROCEEDINGS, PART E vol. 133, no. 1, janvier 1986, STEVENAGE GB pages 54 - 63; M.R.TITCHENER ET AL: "SYNCHRONISATION PROCESS FOR THE VARIABLE-LENGTH T-CODES"

(73) Titulaire: **THOMSON CONSUMER ELECTRO-NICS**
**9, Place des Vosges**
**La Défense 5**
**F-92400 Courbevoie(FR)**

(72) Inventeur: **Le Page, Philippe**
**THOMSON-CSF**
**SCPI**
**Cédex 67**
**F-92045 Paris la Défense(FR)**

(74) Mandataire: **Lincot, Georges et al**
**THOMSON-CSF,**
**SCPI,**
**B.P. 329,**
**50, rue Jean-Pierre Timbaud**
**F-92402 Courbevoie Cédex (FR)**

---

Rank Xerox (UK) Business Services
(3.10/3.09/3.3.3)

IEEE TRANSACTIONS ON INFORMATION THEORY. vol. IT-17, no. 4, juillet 1971, NEW YORK US pages 478 - 487; BEULAH RUDNER: "CONSTRUCTION OF MINIMUM-REDUNDAN-CY CODES WITH AN OPTIMUM SYNCHRONI-ZING PROPERTY"

PATENT ABSTRACTS OF JAPAN vol. 9, no. 332 (E-370)(2055) 26 décembre 1985, & JP-A-60 163548 (MATSUSHITA DENKI SANGYO K.K.) 26 août 1985,

Computer Design, vol.16, No.4 Avril 1977, pages 85 à 90; Y.Dishon: "Data compaction in computer system"

**Description**

La présente invention concerne un procédé de reconnaissance de mots de synchronisation dans des suites de mots codés à longueurs variables. Elle s'applique notamment à la réalisation de systèmes de compression de débit.

Pour limiter en débit des informations transmises entre émetteur et récepteur de télévision numérique, il est souvent fait appel à la méthode de codage statistique de Huffman du type de celle décrite par exemple dans le document Computer Design, volume 16, n° 4, avril 1977 pages 85-90 de Y. DISHON ayant pour titre "Data compaction in Computer Systems". Cette méthode permet en particulier de produire des arbres complets à gauche ou à droite selon le préambule de la revendication indépendante 1. Cependant, la méthode, générale amène à construire des mots de code de longueurs variables dont la longueur maximale qui n'est pas maîtrisable et conduit à des réalisations de dispositifs de codage compliquées. D'autre part, comme les codes ont des longueurs non uniformes, les mots binaires qu'ils forment peuvent être altérés ; ce qui provoque des erreurs de transmission.

Pour limiter la propagation et l'effet de ces erreurs il est nécessaire, d'une manière générale, de découper l'information en blocs en introduisant des mots de synchronisation entre les blocs pour garder la synchronisation des récepteurs en cas d'erreur. Cette protection peut être obtenue selon trois méthodes différentes. Une première méthode consiste à ignorer le type d'information qui est transmis et à placer un mot de synchronisation après un nombre déterminé N de bits utilisés dans la transmission. L'intérêt de cette méthode est qu'elle fixe la longueur des blocs et détermine de façon précise la position des mots de synchronisation. Dans ces conditions il est possible d'utiliser des codes auto-correcteurs d'erreurs pour protéger de façon préférentielle les mots de synchronisation. Une deuxième méthode consiste à placer un mot de synchronisation après N événements codés. Dans ces conditions la position des mots de synchronisation n'est pas connue. Cependant il existe une possibilité de détecter des erreurs car il doit toujours exister un mot de séparation de blocs après N événements. Enfin la troisième méthode consiste à effectuer un codage où le nombre d'événements codés et le nombre de bits par blocs ne sont pas forcément connus. Dans ces deux derniers cas il est primordial de protéger ou au moins de reconnaître les mots de synchronisation afin de localiser efficacement les perturbations causées par les erreurs. Cependant les codes correcteurs existants ne permettent pas de privilégier la protection des mots de synchronisation lorsque les positions de ceux-ci ne sont pas connues.

Le but de l'invention est donc de pallier cet inconvénient.

A cet effet l'invention a pour objet un procédé de codage adapté à la reconnaissance de mots de synchronisation dans des suites de mots codés à longueurs variables, chaque mot codé correspondant à un événement ou message déterminé d'une suite de messages affectés chacun d'une probabilité d'occurrence, consistant à construire un arbre de codage dichotomique comportant un nombre déterminé de feuilles réparties sur des niveaux de priorités classés dans un ordre décroissant en partant de la racine de l'arbre vers les feuilles, le nombre de feuilles étant égal au nombre d'événements N à coder, et consistant à placer les feuilles adjacentes entre elles sur chaque niveau, les feuilles correspondant aux événements les plus probables étant placées à une même extrémité à droite ou à gauche sur chaque niveau, caractérisé en ce qu'il consiste à interdire dans les mots codés des suites d'un nombre déterminé de Smax bits consécutif de même valeur, zéro ou un et à déterminer la longueur du mot de synchronisation comme étant égale à $(3T+2)$ fois le nombre de bits Smax $+ 1$, en plaçant $T + 1$ bits à la même valeur 1 ou 0, T désignant le nombre maximum d'erreurs de transmission de bits tolérées.

L'invention sera mieux comprise et d'autres caractéristiques apparaîtront à l'aide de la description qui suit en référence aux figures annexées qui représentent :
- les figures 1A, 1B et 1C des mots de synchronisation intercalés dans des séquences de bits ;
- la figure 2 une illustration d'une génération d'un arbre de codage complet à gauche dans un algorithme de codage connu, repris dans l'invention ;
- la figure 3 un exemple pour illustrer une structure d'arbre non complet à gauche ;
- la figure 4 un exemple d'obtention d'un arbre de codage complet à gauche comprenant un nombre maximal de zéros égal à 2 ;
- la figure 5 une illustration de la méthode de codage classique de Huffman ;
- la figure 6 une illustration de la méthode de codage connue et mise en oeuvre par l'invention ;
- la figure 7 une illustration de la méthode de codage mise en oeuvre par l'invention obtenue en limitant la profondeur du codage ;
- la figure 8 un organigramme pour illustrer la méthode de codage selon l'invention ;
- les figures 9A et 9B un exemple de mise en oeuvre de la méthode de codage précédente pour limiter la longueur des mots de synchronisation en plaçant des feuilles interdites.

La méthode classique utilisée pour repérer un mot de synchronisation dans une séquence de mots binaires consiste à comparer entre elles le poids de plusieurs séquences de bits successives, chaque séquence comportant un nombre déterminé de bits. Comme ce poids est défini sur une séquence de bits par la somme de tous les bits à "1" de la séquence il est clair qu'en donnant par exemple un poids égal à "0" au mot de synchronisation, ce mot devient parfaitement identifiable parmi les autres séquences qui ont des poids supérieurs à "0".

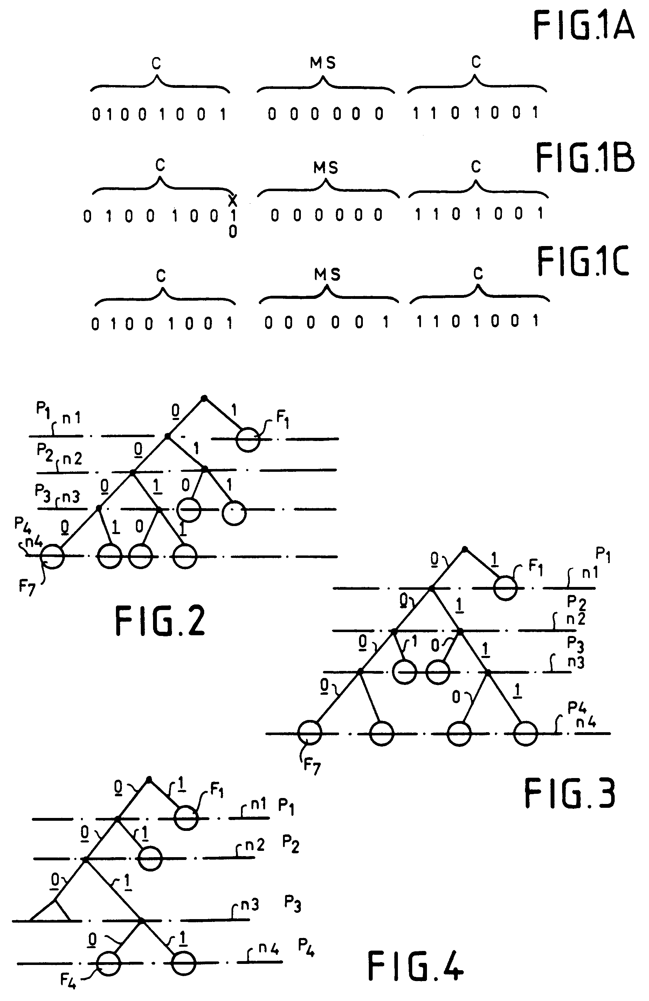

Ainsi dans les séquences de bits représentées à la figure 1A la séquence de six bits à "0' marquée MS et qui est intercalée entre deux séquences marquées C comportant plusieurs bits à "1" est parfaitement reconnaissable puisque son poids est de zéro et que les poids des séquences à gauche et à droite du mot MS sont respectivement de trois et quatre. Par contre, si une erreur intervient par exemple dans la position étoilée du mot C à gauche, le mot MS est reconnu avec cependant une erreur de position comme cela apparaît sur la figure 1B. Il en est de même chaque fois que le mot C se termine par des zéros. Ces problèmes peuvent cependant trouver leur solution en ajoutant comme cela est représenté à la figure 1C un bit à "1" à la fin par exemple du mot de synchronisation MS. La solution se généralise d'ailleurs pour un nombre quelconque de T erreurs. Dans ce cas, la position du mot de synchronisation peut être assurée à la condition qu'il contienne au moins $T+1$ bits à "1". On peut constater en effet sans tenir compte de la position des $T+1$ bits à "1" dans le mot de synchronisation, ni de sa longueur que si T bits à "1" sont effacés dans le mot de synchronisation la position du mot MS est conservée même si celui-ci est précédé de "0" du fait de la présence du "1" restant. Le processus de détection du mot de synchronisation pour MS résulte du produit de convolution de suites Q et MS. En considérant par exemple les transformées en Z du mot de synchronisation MS et de la séquence Q des mots codés tels que

$$MS(Z) = \sum_{L=0}^{S-1} MS_L . Z^{-L} \quad et \quad Q(Z) = \sum_{K=-\infty}^{+\infty} Q_K . Z^{-K}$$

avec $Q_K = MS_K$ pour $K = 0, 1, \ldots S-1$

le produit de convolution de $Q(Z)$ et de $MS(Z)$ s'exprime par la relation

$$Q(Z) \otimes MS(Z) = \sum_{j=-\infty}^{+\infty} (\sum_{L=0}^{S-1} Q_{j+L} \otimes MS_L) Z^J = \sum_{-\infty}^{+\infty} Pj.Z^J \quad (1)$$

où Pj est la distance de Hamming D(Ej.MS) entre la séquence Ej et le mot de synchronisation MS, cette distance pouvant être mesurée par une opération "OU exclusif" entre n'importe quelle séquence de bits située à gauche ou à droite du mot de synchronisation et le mot de synchronisation lui-même. Le mot de synchronisation MS peut alors être identifié en présence de T erreurs si seulement la distance de Hamming Pj définie précédemment est supérieure à $T+1$ pour j différent de 0. Il suffit d'intercaler des bits à "1" dans le mot de synchronisation MS de manière à satisfaire la relation Pj supérieure ou égale à $T+1$ et j plus petit que 0.

Cependant lorsque le nombre d'événements à coder est important la méthode de codage de Huffman conduit à utiliser des mots de synchronisation de longueurs importantes, difficiles à trouver car il faut observer de nombreuses concaténations de mots de code. Pour simplifier la recherche du mot de synchronisation, une première solution peut consister à interdire des suites de 0 ou de 1 dans l'arbre de codage de Huffman. Mais le coût en débit apporté par cette solution peut être très important car la contrainte intervient même sur l'événement le plus probable.

La solution mise en oeuvre par l'invention consiste à définir un algorithme permettant de faciliter le choix des mots de synchronisation, permettant sans contrainte de générer des arbres complets à gauche ou respectivement complets à droite comme cela est représenté sur la figure 2. Un arbre complet à gauche étant un arbre où toutes les feuilles de chaque niveau sont adjacentes c'est-à-dire où il n'existe aucun noeud intermédiaire pour séparer les feuilles sur un même niveau. Sur les figures 2 à 3 les feuilles (F1 ... F4) sont représentées par des cercles et les noeuds intermédiaires par des points.

Pour limiter la longueur du mot de synchronisation, on interdit selon l'invention dans les mots de code des suites de plus de Smax "0" (respectivement Smax "1"). Par exemple sur la figure 4, plus de deux 0 consécutifs sont interdits dans l'arbre de codage et trois "0" sont réservés au mot de synchronisation. De cette façon toutes les suites binaires qui se terminent par Smax + 1"0" (respectivement Smax + 1"1")-conduisent à des feuilles interdites. Un exemple de feuille interdite figure sur la figure 4 par un triangle. La recherche de la longueur à donner au mot de synchronisation MS à partir de l'algorithme précédent doit tenir compte d'une part, du fait que pour assurer la position d'un mot MS en présence de T erreurs au plus, celui-ci doit contenir $T+1$ bits à "1" et d'autre part, du résultat PK de l'opération "OU exclusif" définie par la relation (1) effectuée sur une séquence quelconque de longueur S avec le mot de synchronisation MS. En effet, si aucune erreur n'apparaît le résultat PK est nul et le mot de synchronisation est reconnu en position sans erreur. Cependant en présence de V erreurs inférieur ou égales à T, le résultat PK est inférieur ou égal à T et alors MS est reconnu en position en présence de V erreurs. Par conséquent la distance de Hamming PK minimum (Pmin) de la séquence de C par rapport à MS doit être au moins égal à $T+1$ en présence de T erreurs. Si un mot de synchronisation de S bits tolère la présence de T erreurs au plus on aura au plus T erreurs sur une quelconque séquence de S bits et au pire T bits à "1" seront effacés sur la séquence C. La contribution cumulée sur P est donc pour MS = 0

$$P = Pmin + T + D = 2T+1 + D$$

Comme le mot de synchronisation comporte en fait $T+1$ bits à "1", si au pire $T+1$ bits à "1" d'une séquence quelconque coïncident avec $T+1$ bits à 1 du mot de synchronisation, la contribution de ceux-ci sur le résultat PK est nulle. D'une manière générale, si T bits à "1" d'une séquence quelconque appartenant à C coïncident avec au plus B des $T+1$ bits à "1" du mot de synchronisation, la contribution de ceux-ci est nulle. Ces considérations permettent de définir le poids P qu'il faut donner à une séquence C de longueur S pour obtenir une protection contre T erreurs. Ce poids est défini par la relation

$$P = B + T+1 + T \qquad (2)$$

B étant inférieur ou à égal à $T+1$. Le poids maximal de n'importe quelle séquence de code autre que MS est donc égal à $3T+2$. Par conséquent dans l'hypothèse où on peut être assuré de trouver un poids de "1" tous les (Smax + 1) bits dans les mots codés, la valeur de S représentant la longueur totale du mot de synchronisation vérifie la relation

$$S = P.(Smax + 1) \qquad (3)$$

soit encore

$$S = (3T+2).(Smax + 1) \qquad (4)$$

En résumé, le mot de synchronisation MS doit avoir une longueur S égale à (3T + 2)(Smax + 1) et comporter $T+1$ bits à 1.

Les algorithmes mis en oeuvre par l'invention pour générer les arbres complets à gauche, respectivement à droite, sont empruntés de la méthode conventionnelle de Huffman. Suivant la méthode de Huffman, chaque ensemble de N événements à coder est codé en un ensemble de N mots binaires ou messages ceux-ci étant affectés d'une numérotation telle que le premier message codé corresponde toujours à l'événement le plus probable et que le dernier message N corresponde à l'événement ayant la probabilité d'apparition la plus faible. Les messages 1 à N sont ainsi classés par ordre de priorité tel que

$$P(1) \geqq P(2) \geqq P(3)... \geqq P(N) \qquad (5)$$

avec la condition que

$$\sum_{I=1}^{N} P(I) = 1 \qquad (6)$$

Dans ces algorithmes l'arbre de codage possède une structure binaire qui est soit vide, soit formée d'une racine, ou d'un arbre binaire appelé sous-arbre gauche (S.A.G) ou d'un arbre binaire appelé sous-arbre droit (S.A.D).

Par convention, un arbre vide se ramène à une feuille. Un sous-arbre à gauche est atteint en parcourant une branche affectée de 0 et un sous-arbre droit est atteint en parcourant une branche affectée de 1. Cette structure permet de représenter les N messages par un arbre binaire. Le code se lit en partant de la racine et en parcourant les branches de l'arbre jusqu'au moment où une feuille est rencontrée, chaque feuille représentant un événement parmi les N événements. La succession des bits affectés aux branches qui permet d'accéder à une feuille forme ainsi le code de l'événement correspondant. De la sorte si la longueur L(I) d'un mot de code I, où I appartient à l'ensemble des événements de 1 à N, est déterminée par le nombre de bits contenus dans celui-ci on obtient la longueur moyenne du code par la relation

$$LMOY = \sum_{I=1}^{N} P(I).L(I) \qquad (7)$$

et on doit vérifier l'inégalité

$$L(1) \leqq L(2) \leqq L(3)... \leqq L(N) \qquad (8)$$

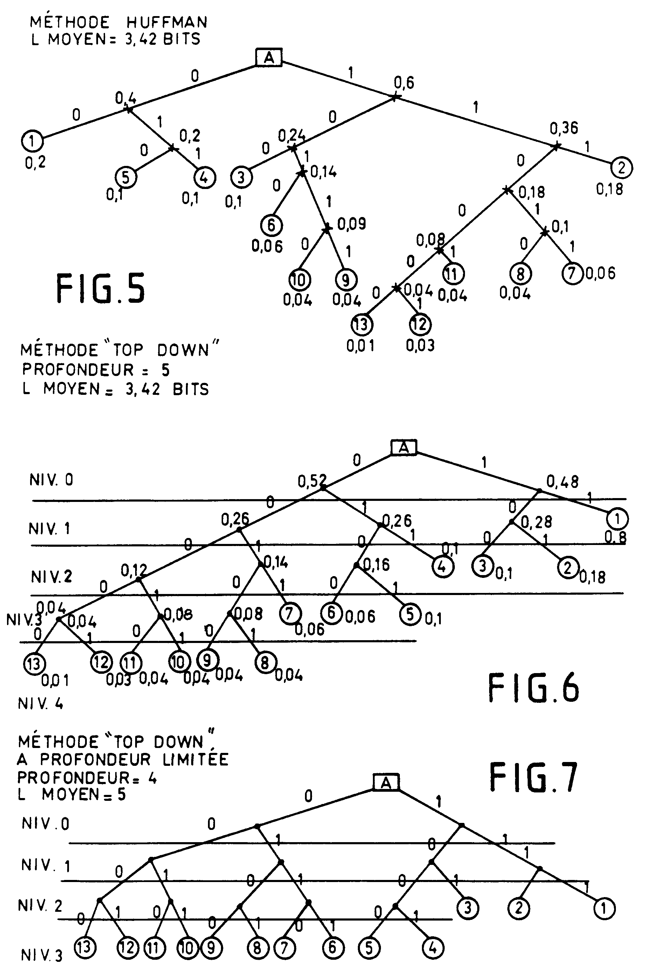

La méthode conventionnelle de Huffman consiste à coder des événements à partir des feuilles pour remonter vers la racine de l'arbre. Suivant l'algorithme de Huffman les N probabilités des messages ou feuilles sont classées dans un ordre croissant et les deux plus faibles probabilités sont isolées pour former la racine d'un arbre porteur de la somme de ces deux probabilités. Les N-1 probabilités restantes sont ensuite réordonnées dans un ordre croissant, puis les opérations précédentes sont recommencées jusqu'au moment où le nombre de probabilités du tri qui est effectué devient nul. Ainsi par exemple le codage de messages A, B, C, D, E, F, G, H, I, J, K, L, M affectés respectivement des probabilités d'occurrences suivantes 0,2 ; 0,18 ; 0,1 ; 0,1 ; 0,1; 0,06 ; 0,06 ; 0,04 ; 0,04 ; 0,04 ; 0,03 et 0,01 et des numéros de feuilles (1, 2, ... 13) donne en utilisant l'algorithme décrit précédemment, l'arbre qui est représenté à la figure 5.

Cependant puisque le codage est déterminé par un déplacement des feuilles vers les racines, la profondeur de l'arbre, qui est aussi celle qui correspond au nombre de bits du mot le moins probable, n'est connue que lorsque celui-ci est construit. Ce fait peut être préjudiciable pour obtenir une faible complexité pratique au codage comme au décodage.

Le procédé selon l'invention pallie cet inconvénient par les algorithmes décrits ci-après qui permettent le codage des événements non pas en parcourant l'arbre de codage des feuilles vers les racines mais à l'inverse en partant de la racine pour descendre vers les feuilles.

Une première méthode appelée "TOP-DOWN" consiste à construire un arbre complet à gauche (respectivement à droite) en essayant chaque fois que les feuilles de messages 1 à K-1 sont placés dans l'arbre à placer la feuille du message K le plus à droite (respectivement à gauche) possible à la profondeur B considérée comme ceci est représenté sur la figure 6 et on détermine le nombre M de feuilles ou de racines de l'arbre à la profondeur B + 1 par la relation

$$M = 2^{L(K)+1}(1 - \sum_{j=1}^{K} 2^{-L(j)}) \qquad (9)$$

Comme dans l'algorithme de Huffman les feuilles ou racines d'arbre K + 1 à K + N sont porteuses d'une probabilité P(I) en tant que feuille ou de somme de probabilités en tant que racine d'arbre. Le fait de chercher à construire un arbre complet à gauche revient à effectuer une simulation de tri par ordre croissant des probabilités à la profondeur B + 1.

Puisque les probabilités sont considérées comme triées si la relation

$$P(K) \gg \sum_{I=M+K}^{N} P(I) \qquad (10)$$

est vérifiée, alors la feuille F(K) peut être considérée comme placée au bon endroit.

Dans le cas contraire si la relation :

$$P(K) < \sum_{I=M+K}^{N} P(I) \qquad (11)$$

est vérifiée alors, il est nécessaire de comparer la probabilité P(K) à la somme des probabilités P(M + K-1) et P(M + K-2) des feuilles K + M-1 et K + M + 2.

Si P(M + K-1) + P(M + K-2) est inférieure à la probabilité P(K) (12), la feuille F(K) n'est pas à sa place et il faut incrémenter de 1 la longueur du code du message K. Par contre si P(M + K-1) + P(M + K-2) est supérieure ou égale à P(K) (13) la seule solution consiste à construire deux arbres, un premier arbre où la feuille F(K) est placée à cet endroit et un deuxième arbre en incrémentant de 1 la longueur du mot de code K.

Les opérations suivantes consistent alors, si la feuille F(K) est considérée placée au bon endroit, à essayer de placer la feuille F(K + 1) à la même profondeur B que la feuille F(K). Mais si la longueur du mot de code K est incrémentée de 1, l'algorithme précédent est à nouveau exécuté jusqu'au moment où la feuille F(K) est effectivement placée. Dans le cas où deux arbres sont à construire l'arbre où la feuille est considérée placée est terminé et les conditions nécessaires à la poursuite de la construction de l'autre arbre sont empilées.

Un programme correspondant permettant l'exécution de l'algorithme décrit précédemment est le suivant.

```
(INITIALISATION POUR LA PREMIERE FEUILLE F1 DU PREMIER ARBRE)
TANT QUE TOUS LES ARBRES NE SONT PAS CONSTRUITS FAIRE :
        TANT QUE L'ARBRE TRAITE N'EST PAS TERMINE FAIRE
            SI I ⩾ N
        ALORS TERMINER L'ARBRE TRAITE

        SINON SI P(K)  ⩾   N
                           Σ      P(I)
                          I=M+K

                ALORS       PLACER LA FEUILLE FK (PHASE D'INITIA-
                            LISATION PRISE EN COMPTE (?))
                  SINON     SI P(K)  ⩾   P(I-1) + P(I-2)
                            ALORS      (CONSTRUIRE DEUX ARBRES)
                                  - FEUILLE FK PLACEE
                                  - LONGUEUR DU MESSAGE
                                  K AUGMENTE DE I (CONDITIONS
                                  EMPILEES)
                            SINON     AUGMENTER LA LONGUEUR DU
                                      MESSAGE K DE 1
                                      (FIN   DE    PHASE   D'INITIA-
                                      LISATION)
                            FSI .
                    FSI ;
                FSI ;
                (LE TRAITEMENT CONTINU TANT QUE L'ARBRE N'EST PAS
                TERMINE)
        FAIT :
        ON GARDE LE MEILLEUR ARBRE, ET ON CONSTRUIT L'ARBRE CORRES-
        PONDANT AUX DERNIERES CONDITIONS EMPILEES. SI LA PILE EST
        VIDE, ON TERMINE
    FAIT ;
    FIN .
```

L'algorithme précédent peut être perfectionné en limitant la profondeur de codage. En effet si Pmax désigne la profondeur maximale de codage autorisée et si le nombre d'événements N est inférieur ou égal à $2^{Pmax}$ il est possible de trouver l'arbre optimum qui possède la profondeur Pmax. Il suffit pour obtenir cet arbre d'imposer au message numéro K d'avoir une longueur incrémentée de 1 si le nombre de feuilles possibles au niveau Pmax est inférieur au nombre de messages restant à placer N-K, comme la variable I = M + K est inférieure au nombre N de feuilles à placer, la contrainte précédente est la plus forte. Cette méthode est intéressante car elle correspond à la contrainte minimale nécessaire à une limitation stricte de la profondeur et elle permet de minimiser la perte sur le débit moyen. Le nombre de feuilles possibles à la profondeur Pmax est alors donné par la relation :

$$FPMAX = 2^{PMAX}(1 - \sum_{j=1}^{K} 2^{-L(j)}) \qquad (14)$$

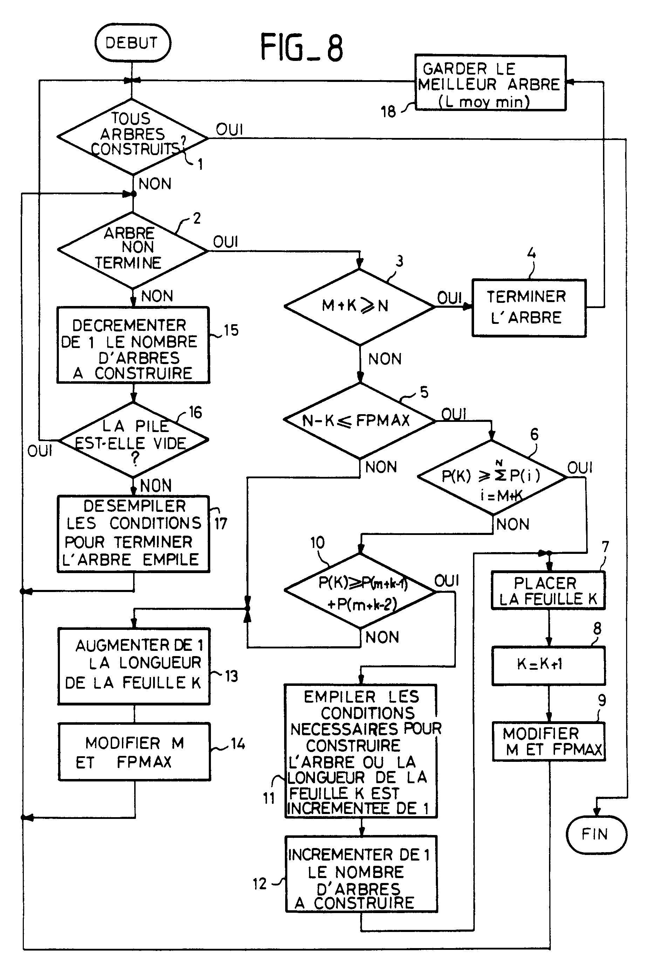

Un programme correspondant dont les étapes 1 à 18 sont illustrées par l'organigramme de la figure 8 est le suivant :

```
(INITIALISATION POUR LA PREMIERE FEUILLE F1 DU PREMIER ARBRE)
TANT QUE TOUS LES ARBRES NE SONT PAS CONSTRUITS FAIRE
        TANT QUE L'ARBRE N'EST PAS TERMINE FAIRE
           SI I  ≥  N
           ALORS TERMINER L'ARBRE TRAITE
           SINON    SI N-K  ≤  FPMAX
                                         N
                     ALORS SI P(K)  ≥  ∑
                                       I=M+K
                           ALORS - PLACER LA FEUILLE FK
                                 (PHASE D'INITIALISATION
                                 PRISE EN COMPTE (?))
                                 - MODIFICATION DE FPMAX.
                           SINON SI P(K)  >   P(I-1) + (P(I-2)
                                 ALORS (CONSTRUIRE DEUX ARBRES)
                                 - FEUILLE FK PLACEE.
                                 - MODIFICATION DE FPMAX.
                                 - LONGUEUR DU MESSAGE K AUGMENTE
                                 DE 1 (CONDITIONS EMPILEES).
                                 SINON AUGMENTER LA LONGUEUR DU
                                       MESSAGE K DE 1
                                       (FIN  DE   PHASE   D'INI-
                                       TIALISATION).
                                       - MODIFICATION DE FPMAX
                           FSI ;
                     FSI .
                     SINON SI N-K > FPMAX
                           ON     DOIT    OBLIGATOIREMENT    AUGMEN-
                           TER DE 1 LA LONGUEUR DU MOT DE
                           CODE   K.   (FIN   DE   PHASE   D'INITIA-
                           LISATION)
                           - MODIFICATION DE FPMAX.
                     FSI ;
```

```
                    (LE TRAITEMENT CONTINU TANT QUE L'ARBRE N'EST PAS
                    TERMINE)
                FAIT ;
                ON GARDE LE MEILLEUR ARBRE, ET ON CONSTRUIT L'ARBRE CORRES-
                PONDANT AUX DERNIERES CONDITIONS EMPILEES. SI LA PILE EST
                VIDE, ON TERMINE.
            FAIT ;
            FIN ;
```

Le respect des contraintes imposées par la recherche du mot de synchronisation à savoir que l'on interdit les suites de plus de Smax "0" dans un arbre et qu'il est introduit des feuilles interdites dans l'arbre retenu, peut être suivi à l'aide d'une représentation particulière suivant un tableau à deux dimensions dans lequel la première dimension verticale représente les niveaux dans l'arbre et la seconde dimension horizontale caractérise la répartition des feuilles-noeuds intermédiaires et feuilles interdites.

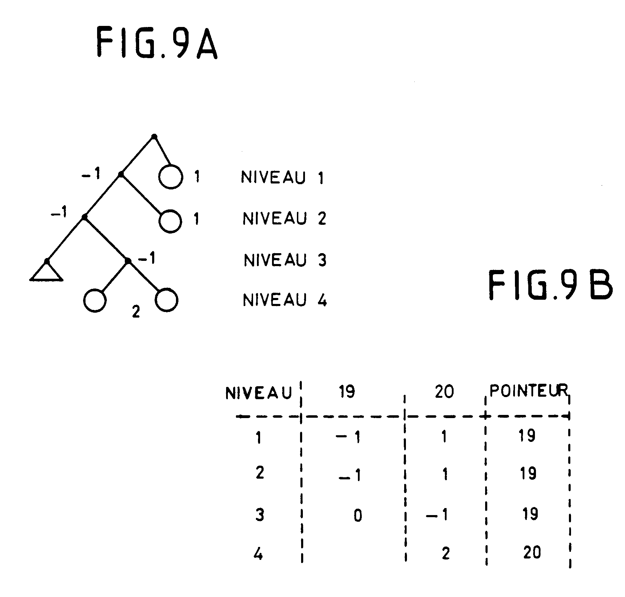

Comme représenté aux figures 9A et 9B un chiffre positif caractérise un nombre de feuilles placées côte à côte dans l'arbre, un chiffre négatif caractérise un nombre de noeuds intermédiaires placés côte à côte et la représentation d'un "0" caractérise une feuille interdite. Le dernier élément de chaque niveau est un pointeur qui indique en permanence l'adresse du dernier élément placé. Ce pointeur fait partie des conditions empilées. Il permet, au dépilage d'un arbre non terminé, de reprendre les calculs à la feuille utile. Si SI désigne une suite de l"0" (respectivement l"1") inférieure ou égale à Smax, pour réaliser la condition sur les suites des "0" il est nécessaire de connaître en permanence au cours de l'exécution de l'algorithme l'ensemble des valeurs des suites SI au niveau courant B et au niveau suivant B + 1. Les suites SI sont des suites de "0" sur lesquelles on essaie de placer les feuilles, les noeuds intermédiaires, les feuilles interdites. En désignant par SIK la suite de "0" de l'arbre où on essaie de placer la feuille courante de numéro K et en respectant la limitation en profondeur, il est nécessaire de calculer en permanence les variations de FPmax en fonction de SIK, LK (longueur du mot de code courant) et Pmax. Deux fonctions sont alors utilisées. La première fonction FP(SIK,LK,Pmax) calcule la modification du nombre de feuilles possible au niveau Pmax lorsque la feuille K est considérée placée, les feuilles 1 à K-1 étant déjà placées dans l'arbre. La deuxième fonction FNP(SIK,LK,Pmax) permet de calculer la modification du nombre de feuilles possible au niveau Pmax, les feuilles 1 à K-1 étant déjà placées dans l'arbre, la feuille K supposée placée voyant sa longueur incrémentée de 1. Les variations du nombre de feuilles au niveau Pmax ne sont calculées qu'une fois si nécessaire, les résultats correspondants sont utilisés de nombreuses fois au cours du déroulement de l'algorithme. Lorsqu'un mot de code numéro K voit sa longueur incrémentée de 1 les feuilles interdites du niveau courant B ne peuvent plus être alors éliminées et elle contribuent à la perte sur la longueur moyenne du code mais peuvent servir par ailleurs pour la détection d'erreurs. Par contre, les feuilles interdites possibles au niveau B + 1 peuvent être éliminées. En effet si ayant placé la feuille numéro K-1 on cherche à placer la feuille numéro K au même niveau sur la suite Smax de 0 une feuille interdite disparaît. Dans le déroulement de l'algorithme toutes les feuilles interdites possibles doivent être considérées.

**Revendications**

1. Procédé de codage adapté à la reconnaissance de mots de synchronisation dans des suites de mots codés à longueurs variables, chaque mot codé correspondant à un événement ou message déterminé d'une suite de messages affectés chacun d'une probabilité d'occurrence, consistant à construire un arbre de codage dichotomique comportant un nombre déterminé de feuilles (F1 ... F4) réparties sur des niveaux de priorités ($n_1$ ... $n_4$) classés dans un ordre décroissant en partant de la racine de l'arbre vers les feuilles, le nombre de feuilles étant égal au nombre d'événements N à coder, et consistant à placer les feuilles adjacentes entre elles sur chaque niveau, les feuilles correspondant aux événements les plus probables étant placées à une même extrémité à droite ou à gauche sur chaque niveau, caractérisé en ce qu'il consiste à interdire dans les mots codés des suites d'un nombre déterminé de Smax bits consécutifs de même valeur zéro ou un et à déterminer la longueur du mot de synchronisation comme étant égale à (3T + 2) fois le nombre de bits Smax + 1, en plaçant T + 1 bits à la même valeur 1 ou 0, T désignant le nombre maximum d'erreurs de transmission de bits tolérées.

**2.** Procédé selon la revendication 1 caractérisé en ce qu'il consiste pour placer une feuille F(K) à un endroit déterminé d'un niveau de priorité ($n_i$) dans l'arbre de codage à comparer sa probabilité P(K) à la somme S des probabilités

$$\sum_{I = M+K}^{N} P(I) = S$$

des feuilles restant à placer, pour placer la feuille F(K) à cet endroit si P(K) est supérieure ou égale à S, à effectuer dans le cas contraire une comparaison de sa probabilité P(K) avec la somme P(M+K-1) + P(M+K-2) des probabilités des feuilles F(M+K-1) et F(M+K-2) situé au niveau de probabilité inférieur pour incrémenter de 1 la longueur du message K, ou conserver la feuille F(K) à cet endroit.

**3.** Procédé selon la revendication 2 caractérisé en ce qu'il consiste à lire les codes des événements en partant de la racine et en parcourant les branches de l'arbre jusqu'au moment ou une feuille est rencontrée.

## Claims

**1.** Encoding method adapted to the recognition of synchronization words in sequences of variable length encoded words, each encoded word corresponding to a specific message or event from a sequence of messages each assigned with a probability of occurrence, consisting in the construction of a dichotomizing encoding tree comprising a specific number of leaves (F1 ... F4) distributed over priority levels ($n_1$ ... $n_4$) classifed in a decreasing order on proceeding from the root of the tree towards the leaves, the number of leaves being equal to the number of events N to be encoded, and consisting in placing the leaves adjacent to one another on each level, the leaves corresponding to the most probable events being placed at a single right or left end on each level, characterized in that it consists in prohibiting, in the encoded words, sequences of a specific number of Smax consecutive bits of equal value, zero or one, and in determining the length of the synchronization word as being equal to (3T+2) times the number of bits Smax+1, placing T+1 bits at equal value 1 or 0, T denoting the maximum number of tolerated bit transmission errors.

**2.** Method according to Claim 1, characterized in that it consists, to place a leaf F(K) at a definite position of a priority level ($n_i$) in the encoding tree, in comparing its probability P(K) with the sum S of the probabilities

$$\sum_{I=M+K}^{N} P(I) = S$$

of the leaves remaining to be placed, to place the leaf F(K) at this position if P(K) is greater than or equal to S, in carrying out in the contrary case a comparison of its probability P(K) with the sum P-(M+K-1) + P(M+K-2) of the probabilities of the leaves F(M+K-1) and F(M+K-2) situated at the lower probability level to increment by 1 the length of the message K, or to maintain the leaf F(K) at this position.

**3.** Method according to Claim 2, characterized in that it consists in reading the event codes by proceeding from the root and by traversing the branches of the tree up until the moment when a leaf is encountered.

## Patentansprüche

**1.** Kodierverfahren, das zur Erkennung von Synchronisationswörtern in Folgen von kodierten Wörtern variabler Länge geeignet ist, wobei jedes kodierte Wort einem Ereignis oder einer bestimmten Nachricht in einer Folge von Nachrichten entspricht, die je mit einer Wahrscheinlichkeit des Auftretens behaftet sind, wobei das Verfahren darin besteht, einen dichotomischen Kodebaum zu konstruieren, der eine bestimmte Anzahl von Blättern (F1 ... F4) enthält, die auf Prioritätsebenen ($n_1$ ... $n_4$) verteilt sind, welche in einer abnehmenden Rangordnung beginnend mit der Wurzel des. Baums und endend bei den Blättern angeordnet werden, wobei die Anzahl von Blättern gleich der Anzahl der zu kodierenden Ereignisse N ist, und wobei weiter das Verfahren darin besteht, die Blätter auf jeder Ebene einander benachbart anzuordnen, wobei die den Ereignissen mit der höchsten Wahrscheinlichkeit entsprechenden Blätter an einem gemeinsamen Ende rechts oder links auf jeder Ebene gesetzt werden, dadurch gekennzeichnet, daß das Verfahren darin besteht, in den kodierten Wörtern die Folgen einer gegebenen Anzahl von Smax aufeinanderfolgender Bits des gleichen Werts "0" oder "1" zu verbieten und die Länge des Synchronisationsworts als gleich (3T+2) mal der Anzahl von Bits Smax+1 zu bestimmen, indem T+1 Bits des gleichen Werts "1" oder "0" gesetzt werden, wobei T die maximale Anzahl von tolerierten Bitfehlern bei der Übertragung bezeichnet.

2. Verfahren nach Anspruch 1, dadurch gekennzeichnet, daß zum Setzen eines Blatts F(K) an einer bestimmten Stelle auf einem Prioritätsniveau ($n_i$) im Kodierbaum dessen Wahrscheinlichkeit P(K) mit der Summe S der Wahrscheinlichkeiten

$$\sum_{I=M+K}^{N} P(I) = S$$

der noch zu setzenden Blätter verglichen wird, um das Blatt F(K) an dieser Stelle zu setzen, wenn P(K) größer oder gleich S ist, wobei im gegenteiligen Fall ein Vergleich der Wahrscheinlichkeit P(K) mit der Summe P(M+K-1)+P(M+K-2) der Wahrscheinlichkeiten der auf der nächstniederen Wahrscheinlichkeitsebene liegenden Blätter F(M+K-1) und F(M+K-2) erfolgt, um die Länge der Nachricht K um eine Einheit zu erhöhen oder das Blatt F(K) an dieser Stelle beizubehalten.

3. Verfahren nach Anspruch 2, dadurch gekennzeichnet, daß es darin besteht, die Kodes der Ereignisse beginnend bei der Wurzel und fortsetzend über die Zweige des Baums bis zu dem Augenblick zu lesen, an dem ein Blatt angetroffen wird.

# FIG.1A

C       M S       C

0 1 0 0 1 0 0 1    0 0 0 0 0 0    1 1 0 1 0 0 1

# FIG.1B

C       M S       C

0 1 0 0 1 0 0 1 X    0 0 0 0 0 0    1 1 0 1 0 0 1
0

# FIG.1C

C       M S       C

0 1 0 0 1 0 0 1    0 0 0 0 0 1    1 1 0 1 0 0 1

FIG.2

FIG.3

FIG.4

MÉTHODE HUFFMAN
L MOYEN= 3,42 BITS

# FIG.5

MÉTHODE "TOP DOWN"
PROFONDEUR = 5
L MOYEN = 3,42 BITS

# FIG.6

MÉTHODE "TOP DOWN",
A PROFONDEUR LIMITÉE
PROFONDEUR = 4
L MOYEN = 5

# FIG.7

# FIG_8

# FIG.9A

-1
-1
-1
1   NIVEAU 1
1   NIVEAU 2
    NIVEAU 3
2   NIVEAU 4

# FIG.9 B

| NIVEAU | 19 | 20 | POINTEUR |
|--------|------|------|----------|
| 1 | − 1 | 1 | 19 |
| 2 | − 1 | 1 | 19 |
| 3 | 0 | − 1 | 19 |
| 4 |  | 2 | 20 |